# EUROPEAN PATENT APPLICATION

(11) **EP 3 896 837 A1**
(43) Date of publication of application: **20.10.2021**
(21) Application number: 20759790.7
(22) Date of filing: 14.02.2020
(51) Int. Cl.: H02N 1/00, B81B 3/00, B81C 1/00, H01G 7/02

(54) **VIBRATING POWER GENERATION ELEMENT AND MANUFACTURING METHOD FOR VIBRATING POWER GENERATION ELEMENT**

(30) Priority: 22.02.2019 JP 2019030950
(71) Applicant: Saginomiya Seisakusho, Inc., Tokyo 165-0033 (JP)
(72) Inventor: ASHIZAWA, Hisayuki, Sayama-shi, Saitama 350-1395 (JP); MITSUYA, Hiroyuki, Sayama-shi, Saitama 350-1395 (JP)
(74) Representative: Kramer Barske Schmidtchen Patentanwälte PartG mbB
(86) International application number: PCT/JP2020/005888
(87) International publication number: WO 2020/170988

(57) **Abstract**

A vibration-driven energy harvesting element is formed by processing a substrate having a first Si layer and a second Si layer with an insulating layer in between. The vibration-driven energy harvesting element includes: a fixed electrode formed in the first Si layer; and a movable electrode formed in the second Si layer, opposed to the fixed electrode with a gap space formed in the insulating layer in between, and movable relative to the fixed electrode.

## Description

### Technical Field

The present invention relates to a vibration-driven energy harvesting element and a method of manufacturing the vibration-driven energy harvesting element.

### Background Art

As one of energy harvesting techniques using environmental vibrations, it is now known that power is generated by a vibration-driven energy harvesting element using a micro electro-mechanical system (MEMS) processing technique. As a vibration-driven energy harvesting element for this purpose, there is proposed an electrostatic vibration-driven energy harvesting element using an electret in order to obtain high power generation efficiency in a compact manner (see PTL 1).

In a vibration-driven energy harvesting element disclosed in PTL 1, a comb-teeth movable electrode and fixed electrode are formed in an active layer of a Silicon On Insulator (SOI) substrate and the movable electrode supported by an elastic support portion vibrates to generate power. In this vibration-driven energy harvesting element, as a gap (electrostatic gap) between the movable electrode and the fixed electrode decreases, the electrostatic capacitance increases, which is advantageous in increasing the amount of power generated. Further, as the gap decreases, electrical damping increases and the Q value of the power generation element can be reduced. In power generation by random vibrations, it is preferable that the Q value be low.

### Citation List

### Patent Literature

PTL 1: Japanese Patent Laid-Open No. 2018-88780

### Summary of Invention

### Technical Problem

However, in the vibration-driven energy harvesting element of PTL 1, since the gap between the movable electrode and the fixed electrode is formed by etching the active layer, which is the same Si layer, into a groove, there is a limit to a reduction in gap size due to the limit of an aspect ratio of MEMS processing. For example, in a case where the thickness of the active layer is several hundred micrometers, the limit of the gap size is about 10 µm.

### Solution to Problem

According to a first aspect of the present invention, a vibration-driven energy harvesting element formed by processing a substrate having a first Si layer and a second Si layer with an insulating layer in between comprises: a fixed electrode formed in the first Si layer; and a movable electrode formed in the second Si layer, opposed to the fixed electrode with a gap space formed in the insulating layer in between, and movable relative to the fixed electrode.

According to a second aspect of the present invention, it is preferable that the vibration-driven energy harvesting element of the first aspect further comprise an elastic support portion formed in the second Si layer and having one end connected to the movable electrode and the other end fixed to the first Si layer with the insulating layer in between.

According to a third aspect of the present invention, it is preferable that in the vibration-driven energy harvesting element of the first or second aspect, the first Si layer be thicker than the second Si layer.

According to a fourth aspect of the present invention, in the vibration-driven energy harvesting element of the first or second aspect, the second Si layer may be thicker than the first Si layer.

According to a fifth aspect of the present invention, it is preferable that in the vibration-driven energy harvesting element of any one of the first to fourth aspects, the fixed electrode and the movable electrode do not overlap each other in a plan view in a vibration stopped state.

According to a sixth aspect of the present invention, a method of manufacturing a vibration-driven energy harvesting element formed by processing a substrate having a first Si layer and a second Si layer with an insulating layer in between comprises: forming the fixed electrode in the first Si layer; forming the movable electrode opposed to the fixed electrode in the second Si layer; and deleting the insulating layer interposed between the fixed electrode and the movable electrode.

### Advantageous Effects of Invention

According to the present embodiment, the gap between the fixed electrode and the movable electrode can be further reduced.

### Brief Description of Drawings

[FIG 1] FIG 1 is a plan view showing a schematic configuration of a vibration-driven energy harvesting element according to an embodiment of the present invention;
[FIG 2] FIG. 2 is a diagram showing cross section A-A and cross section B-B of the vibration-driven energy harvesting element;
[FIG 3] FIG. 3 is a diagram showing a state in which a movable electrode is displaced;
[FIG 4] FIG 4 is a diagram showing an example of a method of manufacturing the vibration-driven energy harvesting element;
[FIG 5] FIG 5 is a diagram showing the example of the method of manufacturing the vibration-driven energy harvesting element and shows steps subsequent to FIG 4;
[FIG 6] FIG 6 is a diagram showing the example of the method of manufacturing the vibration-driven energy harvesting element and shows steps subsequent to FIG 5;
[FIG 7] FIG 7 is a diagram showing the example of the method of manufacturing the vibration-driven energy harvesting element and shows steps subsequent to FIG 6;
[FIG 8] FIG 8 is a diagram showing a comparative example; and
[FIG 9] FIG 9 is a diagram illustrating overlap between fixed comb teeth and movable comb teeth in a stopped state.

### Description of Embodiments

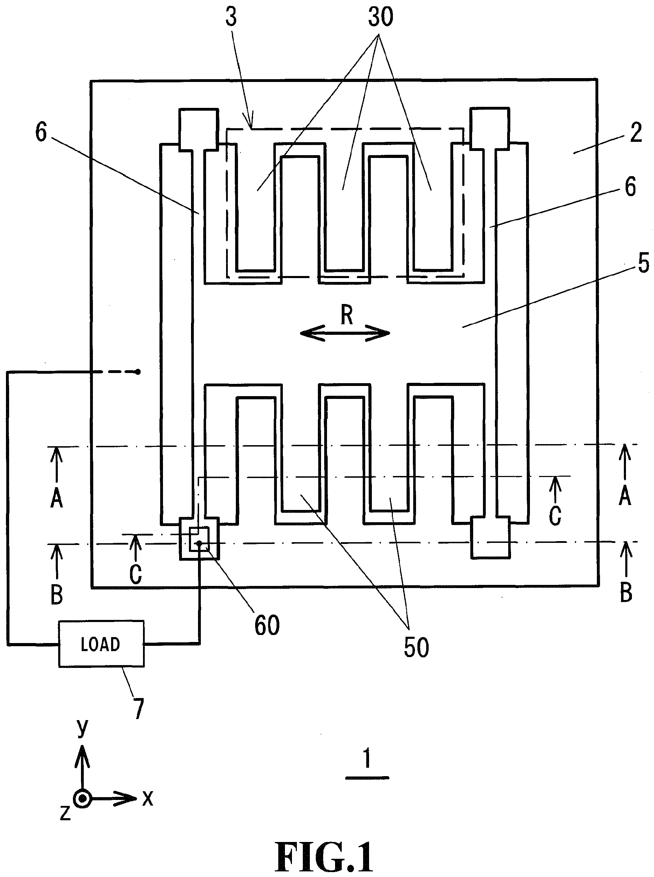

Embodiments of the present invention will be described hereinafter with reference to the drawings. FIG 1 is a plan view showing a schematic configuration of a vibration-driven energy harvesting element 1 according to an embodiment of the present invention. For example, the vibration-driven energy harvesting element 1 is formed by a general MEMS processing technique using a Silicon On Insulator (SOI) substrate. The SOI substrate (hereinafter referred to as an SOI substrate 10) is a substrate having a three-layer structure including an Si layer (hereinafter referred to as an Si layer 10a) called a handle layer, support layer, or the like, an SiO₂ layer (hereinafter referred to as an insulating layer 10b) called a BOX layer or the like, and an Si layer (hereinafter referred to as an Si layer 10c) called a device layer, an active layer, or the like.

In general, the Si layers 10a and 10c of the SOI substrate 10 have a thickness of about 100 to 500 µm and the insulating layer 10b (SiO₂ layer) has a thickness of about several micrometers (e.g., 1 to 3 µm). As an example, the following description is based on the assumption that the Si layer 10a is 400 µm, the Si layer 10c is 100 µm, and the insulating layer 10b is 1 µm.

The vibration-driven energy harvesting element 1 comprises a support portion 2, a fixed electrode 3, a movable electrode 5, and an elastic support portion 6. The elastic support portion 6 is provided with a connection electrode 60 and a load 7 is connected between the back side of the support portion 2 and the connection electrode 60. Incidentally, the description below employs an xyz orthogonal coordinate system set as shown in FIG 1.

The fixed electrode 3 is provided in the support portion 2. The support portion 2 and the fixed electrode 3 are formed in the Si layer 10a of the SOI substrate 10. The movable electrode 5 is elastically supported by four elastic support portions 6. One end of each elastic support portion 6 is connected to the movable electrode 5 and the other end is fixed to the support portion 2. The movable electrode 5 and the elastic support portions 6 are formed in the Si layer 10c of the SOI substrate 10. The other end of each elastic support portion 6 mentioned above is fixed to the support portion 2 of the Si layer 10a with the insulating layer 10b of the SOI substrate 10 in between.

In the present embodiment, the fixed electrode 3 and the movable electrode 5 are comb-teeth electrodes. The fixed electrode 3 comprises a plurality of fixed comb teeth 30 elongated in the y direction and the movable electrode 5 also comprises a plurality of movable comb teeth 50 elongated in the y direction. In the plan view, the fixed comb teeth 30 and the movable comb teeth 50 are alternately arranged in the x direction. The movable electrode 5 elastically supported by the elastic support portions 6 vibrates in the x direction as shown by arrow R in a case where an external force is applied to the vibration-driven energy harvesting element 1.

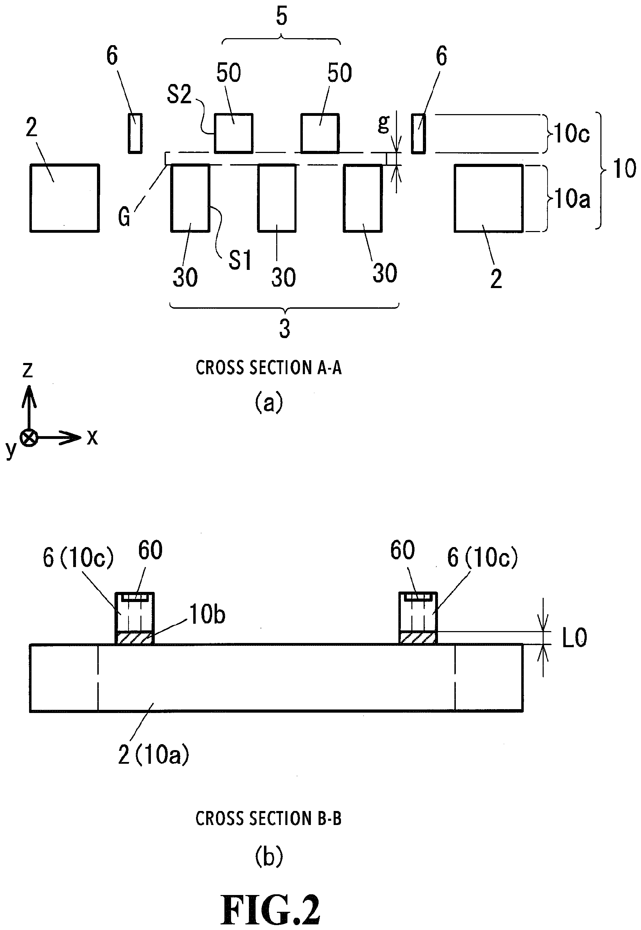

FIG 2 is a diagram showing cross sections of the vibration-driven energy harvesting element 1 shown in FIG 1. FIG 2 (a) shows cross section A-A and FIG 2 (b) shows cross section B-B. Cross section A-A of FIG 2 (a) is a cross-sectional view through the fixed comb teeth 30 and the movable comb teeth 50, where the movable comb teeth 50 and the elastic support portions 6 are arranged at a gap dimension g away from the fixed comb teeth 30 formed in the Si layer 10a in the upward direction (plus direction of the z axis) in the drawing. In other words, the movable electrode 5 is opposed to the fixed electrode 3 with a gap space G formed in the insulating layer 10b in between. The movable comb teeth 50 and the elastic support portions 6 are formed in the Si layer 10c and the gap space G is formed by removing the insulating layer 10b between the fixed electrode 3 (Si layer 10a) and the movable electrode 5 (Si layer 10c). Accordingly, the gap dimension g is equal to a thickness dimension L0 of the insulating layer 10b interposed between the Si layer 10a and the Si layer 10c.

As described above, the movable comb teeth 50 (movable electrode 5) shown in FIG 2 (a) vibrate in the horizontal direction (x direction) in the drawing with respect to the fixed comb teeth 30 (fixed electrode 3) below. Incidentally, although the position of a right side surface S1 of the fixed comb teeth 30 in the x direction is the same as the position of a left side surface S2 of the movable comb teeth 50 in the x direction in FIG 2 (a), FIG 1 and FIG 2 show a slight gap provided between the positions.

Cross section B-B of FIG 2 (b) is a cross-sectional view through the other ends of the elastic support portions 6 (portions fixed to the support portion 2). The other ends of the elastic support portions 6 are fixed to the support portion 2 formed in the Si layer 10a with the insulating layer 10b (SiO2 layer) of the SOI substrate 10 in between.

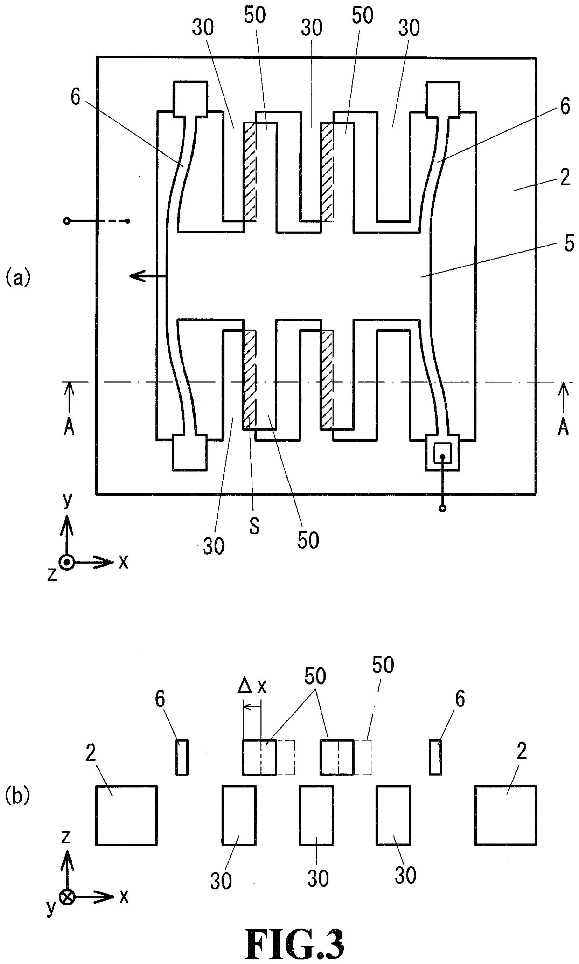

FIG 1 shows a neutral state in which the movable electrode 5 is at rest, whereas FIG 3 shows a state in which the movable electrode 5 is displaced by Δx in the minus direction of the x axis. FIG 3 (a) is a plan view and FIG 3 (b) shows cross section A-A. In the state in which the movable electrode 5 is at rest, overlap between the fixed comb teeth 30 and the movable comb teeth 50 in the plan view is zero.

On the other hand, in a case where the movable electrode 5 is displaced by Δx in the minus direction of the x axis as shown in FIG 3, an area S of overlap between the fixed comb teeth 30 and the movable comb teeth 50 in the plan view is S=L×Δx, where L represents a length of overlap between the fixed comb teeth 30 and the movable comb teeth 50 in the y direction. Since there are four overlapping regions in total, the total amount of increase in overlapping area is 4S. In a case where the area of the overlapping region is S, an electrostatic capacitance C is C=ε×S/g. Thus, the displacement Δx of the movable electrode 5 increases the electrostatic capacitance between the fixed comb teeth 30 and the movable comb teeth 50 by 4C=4×ε×S/g. Here, ε represents permittivity of a medium (air in this case) between the fixed comb teeth 30 and the movable comb teeth 50.

In the vibration-driven energy harvesting element 1, power is generated by such a change in electrostatic capacitance by vibrations of the movable electrode 5. Since the amount of power generated depends on the change in electrostatic capacitance, a large amount of power can be generated as the gap dimension g decreases. In the present embodiment, since the gap dimension g is equal to the thickness of the insulating layer 10b provided between the Si layer 10a and the Si layer 10c, it is easy to set a smaller gap dimension between the fixed electrode and the movable electrode as compared with the case of forming the fixed electrode and the movable electrode in the same Si layer like the above-described vibration-driven energy harvesting element disclosed in PTL 1.

### Method of Manufacturing Vibration-Driven Energy Harvesting Element 1

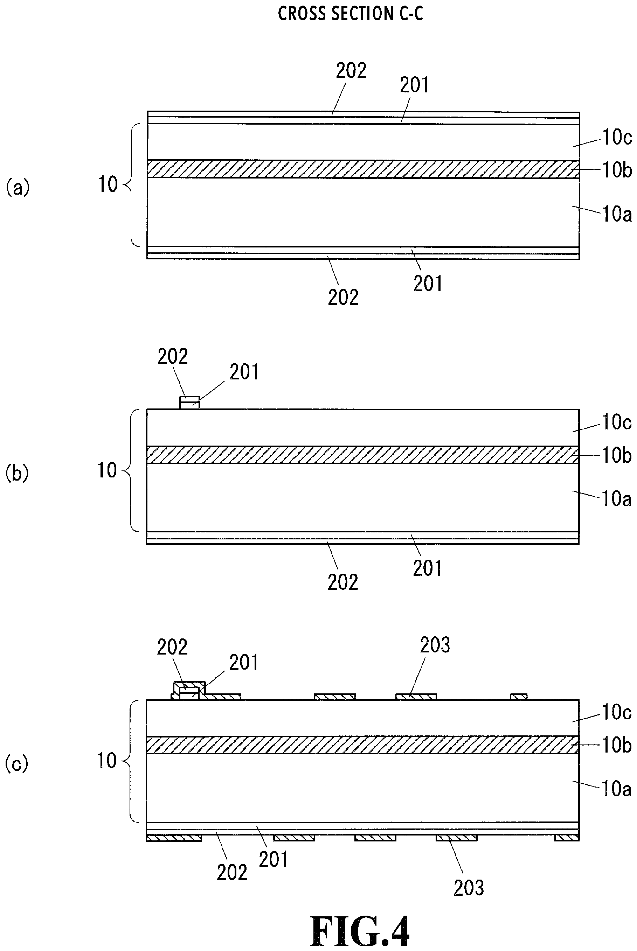

FIG 4 to FIG 7 are diagrams showing an example of a method of manufacturing the vibration-driven energy harvesting element 1. The cross-sectional views of FIG 4 to FIG 7 show cross section C-C in FIG 1. In the step shown in FIG 4 (a), a SiN film 201 and a Poly-Si film 202 are formed by LP-CVD on both of the front and back surfaces of the SOI substrate 10. The SOI substrate 10 includes three layers: the Si layer 10a, the insulating layer 10b, and the Si layer 10c.

In the step shown in FIG 4 (b), a resist mask is formed on the front surface (surface on the Si layer 10c side) of the SOI substrate 10 to leave the SiN film 201 and the Poly-Si film 202 in a region in which the connection electrode 60 is to be formed, and the SiN film 201 and the Poly-Si film 202 are etched by reactive ion etching (RIE) using SF₆ and CF₄. As a result, a pattern of the SiN film 201 and the Poly-Si film 202 is formed on the surface of the Si layer 10c as shown in FIG 4 (b).

In the step shown in FIG 4 (c), after an Al vapor deposition film 203 is formed on both of the front and back surfaces of the substrate, resist masks (not shown) are formed to etch the Al vapor deposition films 203 and the resist masks are used to form Al mask patterns to etch the Si layer 10a and the Si layer 10c.

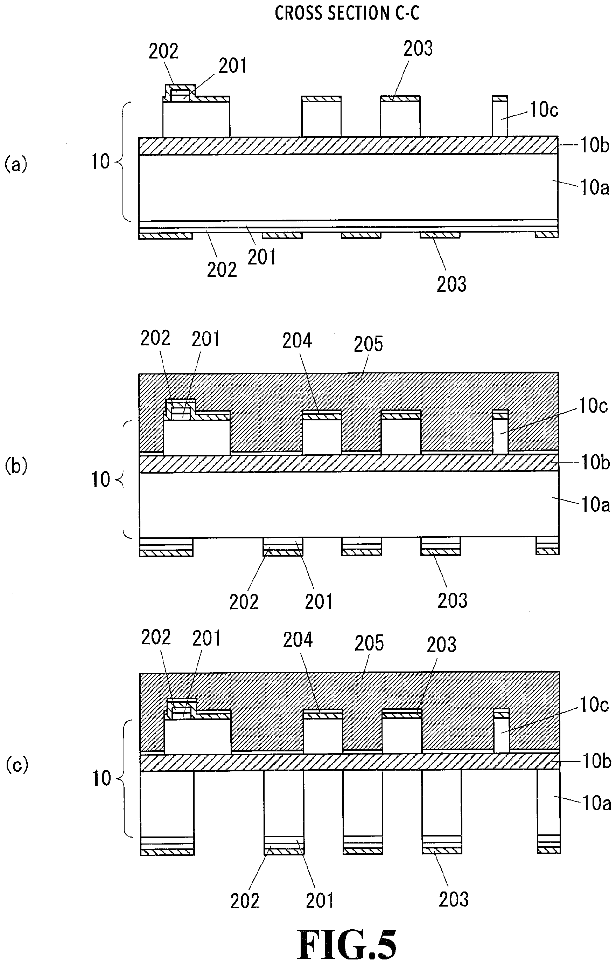

In the step shown in FIG 5 (a), the Si layer 10c of the SOI substrate 10 is etched by DeeP-RIE using the Al mask pattern formed from the Al vapor deposition film 203 on the surface of the Si layer 10c.

In the step shown in FIG 5 (b), a protective aluminum vapor deposition film 204 and resist film 205 are formed on the Si layer 10c side of the SOI substrate 10. After that, the Al mask pattern formed from the Al vapor deposition film 203 on the surface of the Si layer 10a is used to etch the SiN film 201 and the Poly-Si film 202 on the surface of the Si layer 10a.

In the step shown in FIG 5 (c), the Si layer 10a is etched by DeeP-RIE using the mask pattern formed from the SiN film 201, the Poly-Si film 202, and the Al vapor deposition film 203 formed on the Si layer 10a.

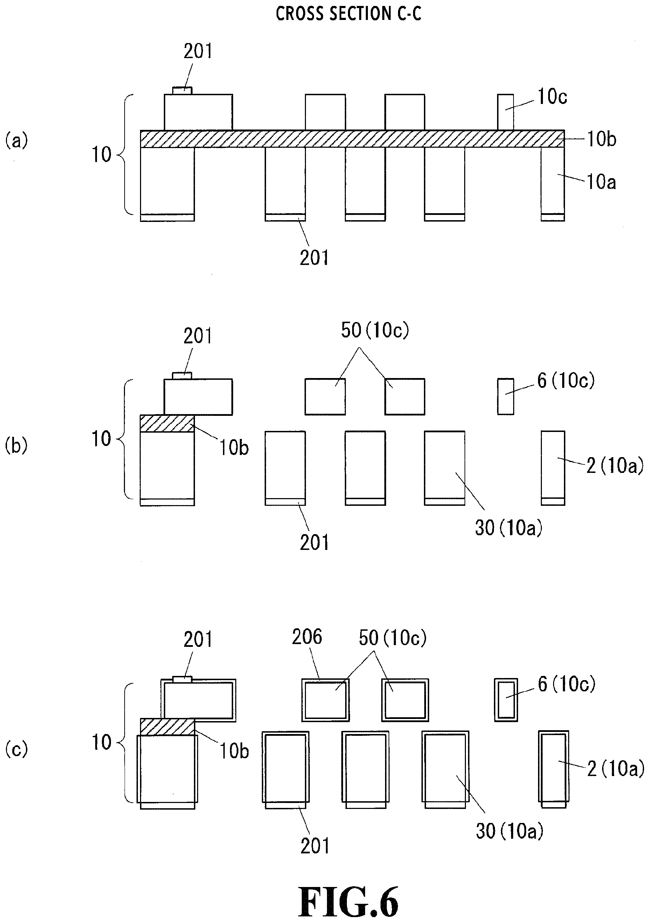

In the step shown in FIG 6 (a), the resist film 205, the Poly-Si films 202, and the Al vapor deposition films 203 and 204 on the substrate are removed by sulfuric acid peroxide mixture (SPM) cleaning.

In the step shown in FIG 6 (b), the exposed insulating layer 10b (SiO₂) is removed by wet etching using buffered hydrofluoric acid (BHF). The insulating layer 10b is etched by BHF through through-holes formed by DeeP-RIE in the Si layer 10a and the Si layer 10c, whereby the fixed comb teeth 30 are separated from one another and the movable comb teeth 50 are separated from one another.

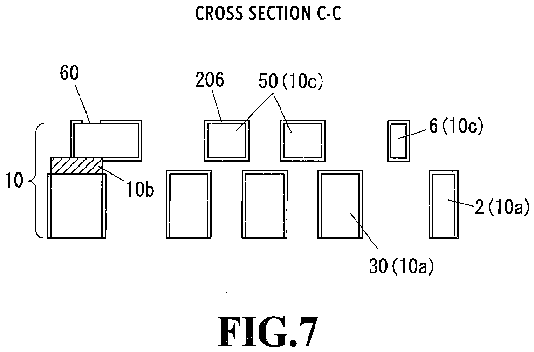

In the step shown in FIG 6 (c), a SiO₂ film 206 including alkali metal ions (such as potassium ions) is formed on the surfaces of the Si layer 10a and the Si layer 10c to form an electret film. FIG 2 omits showing the SiO₂ film 206 including alkali metal ions to form an electret. In the step shown in FIG 7, the SiN films 201 formed on the Si layer 10a and Si layer 10c are removed by RIE using CF₄ gas. A region on the Si layer 10c from which the SiN film 201 has been removed forms the connection electrode 60 shown in FIG 1. The Si layer 10a is also exposed on the back surface of the support portion 2 and the exposed surface is connected to the load 7 shown in FIG 1.

Through the processing steps described above, a MEMS processed body of the vibration-driven energy harvesting element 1 without an electret is formed. After that, an electret is formed on the fixed electrode 3 and/or the movable electrode 5 by a well-known electret formation method (for example, see Japanese Patent No. 5627130). Incidentally, in the vibration-driven energy harvesting element 1 shown in FIG 1, the SiO₂ film 206 of the movable electrode 5 is caused to charge the electret.

### Comparative Example

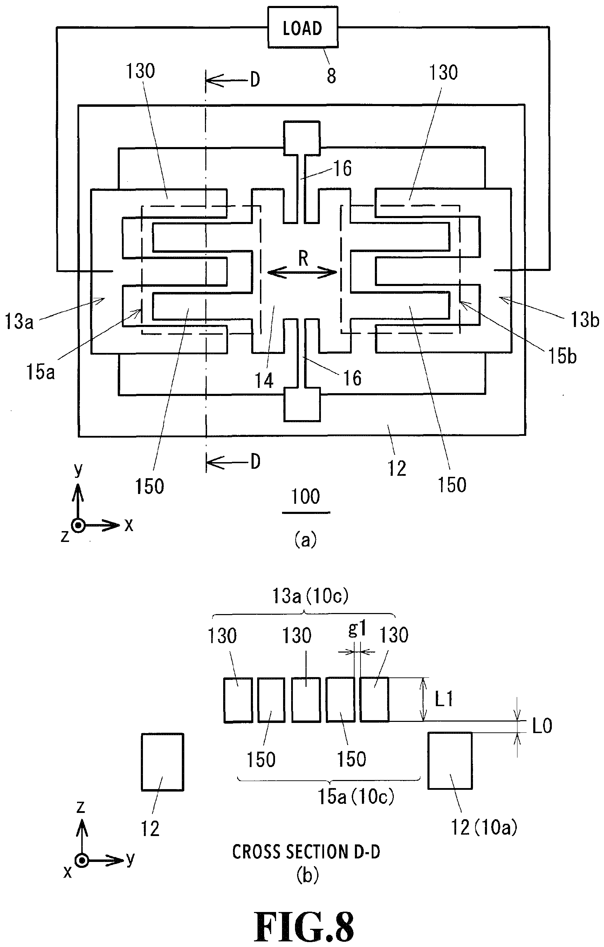

FIG 8 is a diagram showing a comparative example and shows an example of a vibration-driven energy harvesting element in which the fixed electrode and the movable electrode are formed in the Si layer 10c (active layer) of the SOI substrate. FIG 8 (a) is a plan view of a vibration-driven energy harvesting element 100 and FIG 8 (b) shows cross section D-D. The vibration-driven energy harvesting element 100 comprises a support portion 12, fixed electrodes 13a and 13b, a movable portion 14, movable electrodes 15a and 15b, and elastic support portions 16. A load 8 is connected to the fixed electrode 13a on the left side of the drawing and the fixed electrode 13b on the right side of the drawing. The movable portion 14 is elastically supported by a pair of elastic support portions 16. The other end of each elastic support portion 16 is fixed to the support portion 12.

As shown in cross section D-D of FIG 8 (b), the support portion 12 is formed in the Si layer 10a and the fixed electrode 13a and the movable electrode 15a are formed in the Si layer 10c. Similarly, the fixed electrode 13b and the movable electrode 15b are also formed in the Si layer 10c. An interval between the support portion 12 and each of the fixed electrode 13a and the movable electrode 15a in the z direction is equal to the thickness dimension L0 of the insulating layer of the SOI substrate.

Each of the fixed electrodes 13a and 13b and the movable electrodes 15a and 15b forms a comb-teeth electrode. In the fixed electrodes 13a and 13b, a plurality of fixed comb teeth 130 elongated in the x direction are arranged in the y direction. In the movable electrodes 15a and 15b, a plurality of movable comb teeth 150 elongated in the x direction are arranged in the y direction. The fixed comb teeth 130 and movable comb teeth 150 arranged alternately in the y direction are engaged with each other with a gap in between such that the side surfaces of the fixed comb teeth 130 are opposed to the side surfaces of the movable comb teeth 150 with a gap g1 in between.

In a case where an external force is applied to the vibration-driven energy harvesting element 100, the elastic support portions 16 are deformed and the movable portion 14 vibrates in the x direction as shown by arrow R. In a case where the movable portion 14 vibrates, the electrostatic capacitance between the fixed electrodes 13a and 13b and the movable electrodes 15a and 15b is changed and power is generated. Since the electrostatic capacitance between the fixed comb teeth 130 and the movable comb teeth 150 engaged with each other increases as the gap g1 decreases, the amount of power generated also increases as the gap g1 decreases.

The gap g1 between the fixed comb teeth 130 and the movable comb teeth 150 is formed by etching the Si layer 10c by DeeP-RIE. In this case, if the aspect ratio of the gap g1 (=L1/g1) increases (for example, exceeds 10), accurate etching processing becomes difficult. Since the thickness L1 of the Si layer 10c is about one hundred to several hundred micrometers, the gap g1 needs to be at least about 10 µm. As described above, there is a limit to processing for reducing the gap g1, which is one of impediments to an increase in capacity (i.e., an increase in amount of power generated). In addition, in the case of the vibration-driven energy harvesting element 100, since the aspect ratio is high, etching on the side surface of the electrode is not negligible and it is difficult to keep the gap g1 constant.

In contrast, in the vibration-driven energy harvesting element 1 of the present embodiment, the gap dimension g between the fixed electrode 3 and the movable electrode 5 is equal to the thickness L0 of the insulating layer 10b. Thus, the gap dimension g can be reduced to about several micrometers, which facilitates increasing the amount of power generated and forming the gap space G with a constant gap dimension g. Further, since each of the gap between the fixed comb teeth 30 and the gap between the movable comb teeth 50 is greater than the gap between the electrodes of the vibration-driven energy harvesting element 100 as shown in FIGS. 1 and 2, etching processing can be easily performed.

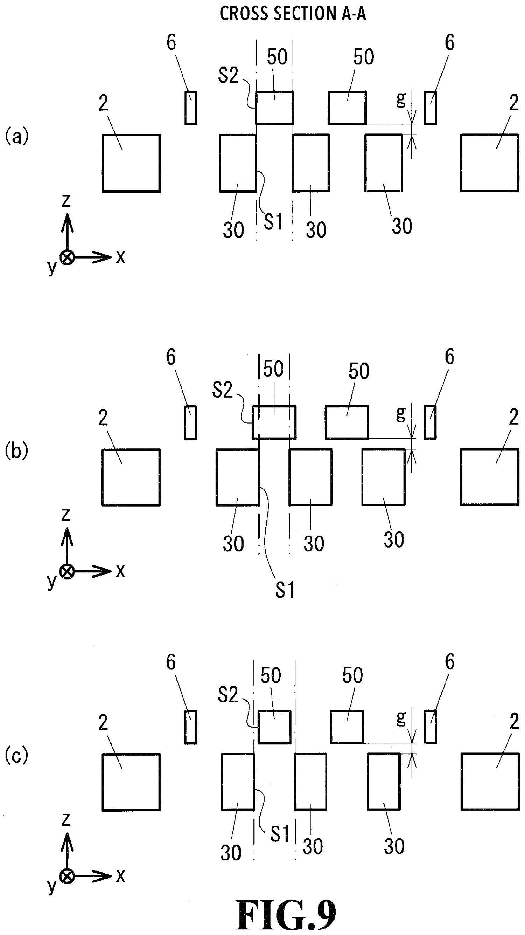

FIG 9 is a cross-sectional view illustrating the conditions of overlap between the fixed comb teeth 30 and the movable comb teeth 50 in a stopped state, that is, overlap between the comb teeth when seen in the plan view. In the present embodiment, as shown in FIG 9 (a), the position of the side surface S1 of the fixed comb teeth 30 in the x direction corresponds to the position of the side surface S2 of the movable comb teeth 50 in the x direction.

In the example shown in FIG 9 (b), the width dimension of the movable comb teeth 50 in the x direction is greater than the gap dimension between the fixed comb teeth 30, and both of the left and right end regions of the movable comb teeth 50 overlap the fixed comb teeth 30 in a stopped state. In such a case where the movable comb teeth 50 overlap the fixed comb teeth 30 in a stopped state, there is a problem that the movable electrode 5 is hard to move due to an electrostatic force between the comb teeth when an external shock is applied.

In contrast, in the example shown in FIG 9 (c), the width dimension of the movable comb teeth 50 in the x direction is less than the gap dimension between the fixed comb teeth 30, and when seen in a plan view in a stopped state, there is a gap between the side surface S1 of the fixed comb teeth 30 and the side surface S2 of the movable comb teeth 50. In such a case where there is a gap, the movable electrode 5 is easy to move when an external shock is applied. However, there is a problem of a reduction in amount of power generated by vibrations of the movable comb teeth 50.

The advantageous results of the embodiment described above can be summarized as follows. (1) As shown in FIG 2, the vibration-driven energy harvesting element 1 is formed by processing the SOI substrate 10 having the Si layer 10a and the Si layer 10c with the insulating layer 10b in between, and comprises the fixed electrode 3 formed in the Si layer 10a and the movable electrode 5 formed in the Si layer 10c, opposed to the fixed electrode 3 with the gap space G formed in the insulating layer 10b in between, and movable relative to the fixed electrode 3. Since the gap space G formed in the insulating layer 10b is a region from which the insulating layer 10b has been removed, the gap dimension g can be equal to the thickness dimension L0 of the insulating layer 10b and the gap dimension g can be reduced irrespective of the limitation of the aspect ratio in etching of the Si layer. As a result, the electrostatic capacitance between the fixed electrode 3 and the movable electrode 5 can be larger and an increase in amount of power generated can be facilitated.

(2) The vibration-driven energy harvesting element 1 further comprises the elastic support portions 6 which are formed in the Si layer 10c and each have one end connected to the movable electrode 5 and the other end fixed to the Si layer 10a with the insulating layer 10b in between. The movable electrode 5 is elastically supported by the elastic support portions 6. The elastic support portions 6 are elastically deformed, whereby the movable electrode 5 vibrates with respect to the fixed electrode 3.

(3) In the example shown in FIG 2, the fixed electrode 3 is formed in the thick Si layer 10a and the movable electrode 5 is formed in the thin Si layer 10c. Alternatively, the fixed electrode 3 may be formed in the Si layer 10c and the movable electrode 5 may be formed in the Si layer 10a. In the former case of forming the fixed electrode 3 in the thick Si layer 10a, the support portion 2 can be formed in the thick Si layer 10a and the rigidity of the support portion 2 can be increased. In the latter case of forming the movable electrode 5 in the thick Si layer 10a, since the elastic support portion 6 is also formed in the thick Si layer 10a, the rigidity of the elastic support portion 6 in the substrate thickness direction can be improved and the displacement of the movable electrode 5 in the direction of the fixed electrode 3 by the electrostatic force can be suppressed.

(4) It is preferable that the fixed electrode 3 and the movable electrode 5 do not overlap each other in a plan view in a vibration stopped state as shown in FIGS. 9 (a) and 9 (c). This configuration can avoid the difficulty in movement of the movable electrode 5 by the electrostatic force between the comb teeth when an external shock is applied.

Although various embodiments and modifications are described above, the present invention is not limited to these contents. Other embodiments considered within the scope of the technical idea of the present invention are also included in the scope of the present invention.

The contents of the disclosure of the following application, upon which priority is claimed, and patent gazette are hereby incorporated herein by reference.
Japanese Patent Application No. 2019-030950 (filed on February 22, 2019)
Japanese Patent No. 5627130

### Reference Signs List

1... vibration-driven energy harvesting element 1, 2... support portion, 3... fixed electrode, 5... movable electrode, 6... elastic support portion, 10... SOI substrate, 10a, 10c... Si layer, 10b... insulating layer, 30... fixed comb teeth, 50... movable comb teeth, G... gap space

## Claims

1. A vibration-driven energy harvesting element formed by processing a substrate having a first Si layer and a second Si layer with an insulating layer in between, the vibration-driven energy harvesting element comprising:
a fixed electrode formed in the first Si layer; and
a movable electrode formed in the second Si layer, opposed to the fixed electrode with a gap space formed in the insulating layer in between, and movable relative to the fixed electrode.

2. The vibration-driven energy harvesting element according to claim 1, further comprising an elastic support portion formed in the second Si layer and having one end connected to the movable electrode and the other end fixed to the first Si layer with the insulating layer in between.

3. The vibration-driven energy harvesting element according to claim 1 or 2, wherein the first Si layer is thicker than the second Si layer.

4. The vibration-driven energy harvesting element according to claim 1 or 2, wherein the second Si layer is thicker than the first Si layer.

5. The vibration-driven energy harvesting element according to any one of claims 1 to 4, wherein the fixed electrode and the movable electrode do not overlap each other in a plan view in a vibration stopped state.

6. A method of manufacturing a vibration-driven energy harvesting element formed by processing a substrate having a first Si layer and a second Si layer with an insulating layer in between, the method comprising:
forming the fixed electrode in the first Si layer;
forming the movable electrode opposed to the fixed electrode in the second Si layer; and
deleting the insulating layer interposed between the fixed electrode and the movable electrode.
